# EUROPÄISCHE PATENTANMELDUNG

(11) **EP 0 975 076 A1**
(43) Veröffentlichungstag der Anmeldung: **26.01.2000**
(21) Anmeldenummer: 98113927.2
(22) Anmeldetag: 24.07.1998
(51) Int. Cl.: H02B 1/28, H05K 5/02, F16K 24/00

(54) **Be- und Entlüftungsverschraubung**

(71) Anmelder: Lagra Elektrotechnik GmbH, 69245 Bammental (DE)
(72) Erfinder: Kloss, Achim, 69115 Heidelberg (DE); Landgraf, Gerhard, 69151 Neckargemünd (DE)
(74) Vertreter: Meyer-Roedern, Giso, Dr.

(57) **Zusammenfassung**

Die Verschraubung hat einen im wesentlichen zylindrischen Hohlkörper (10). Das innere Ende des Hohlkörpers (10) ist als Gewindestutzen (12) ausgebildet. Der Hohlkörper (10) ist außen mit einer Stirnwand (18) verschlossen und an seinem Mantel mit wenigstens einem Schlitz (22) versehen. In den Hohlkörper (10) ist ein Rohrstutzen (30) eingelassen, der sich mit Abstand von der Mantelinnenwand des Hohlkörpers (10) über den Schlitz (22) hinweg bis dicht vor die Stirnwand (18) des Hohlkörpers (10) erstreckt.

## Beschreibung

Die Erfindung betrifft eine Be- und Entlüftungsverschraubung.

Derartige Verschraubungen sind aus der Praxis bekannt. Sie dienen dazu, einen Druckausgleich zwischen dem Innern eines Gehäuses und der Umgebungsluft herbeizuführen. Be- und Entlüftungsverschraubungen kommen insbesondere an elektrischen Schaltschränken zum Einsatz. Sie sollen beim Erwärmen und Abkühlen einen Luftaustausch ermöglichen, ein Eindringen von Spritzwasser und Verunreinigungen aber verhindern.

Aufgabe der Erfindung ist es, eine Be- und Entlüftungsverschraubung mit einem labyrinthartigen Strömungsweg für die Luft zu schaffen, durch den ein wirksamer Luftaustausch ohne Zutritt von Spritzwasser und Verunreinigungen gewährleistet ist.

Die diese Aufgabe lösende Verschraubung hat einen im wesentlichen zylindrischen Hohlkörper, dessen inneres Ende als Gewindestutzen ausgebildet und der außen mit einer Stirnwand verschlossen und an seinem Mantel mit wenigstens einem Schlitz versehen ist. In den Hohlkörpern ist ein Rohrstutzen eingelassen, der sich mit Abstand von der Mantelinnenwand des Hohlkörpers über den Schlitz hinweg bis dicht vor die Stirnwand des Hohlkörpers erstreckt.

Bei einer bevorzugten Ausführungsform hat der Gewindestutzen ein Außengewinde.

Bei einer bevorzugten Ausführungsform hat der Hohlkörper außen vor dem Gewindestutzen einen Flansch mit Außensechskant, an dem ein Schraubenschlüssel angreift. Durch den Flansch ist die Einschraubtiefe des Hohlkörpers begrenzt.

Bei einer bevorzugten Ausführungsform ist die Stirnwand des Hohlkörpers nach außen gewölbt. Dadurch ist sichergestellt, daß kein Wasser auf der Verschraubung steht.

Der Schlitz an dem Mantel des Hohlkörpers erstreckt sich vorzugsweise in Umfangsrichtung. Bei einer bevorzugten Ausführungsform sind wenigstens zwei axial auf gleicher Höhe liegende Schlitze vorgesehen.

Der Rohrstutzen ist vorzugsweise zylindrisch und koaxial in dem Hohlkörper aufgenommen.

Bei einer bevorzugten Ausführungsform hat der Hohlkörper eine axiale Zylinderöffnung. Der Rohrstutzen ist Teil eines im Durchmesser abgestuften zylindrischen Einsatzes, dessen Montagepartie größeren Durchmessers in die Zylinderöffnung paßt.

Die Montagepartie größeren Durchmessers des Einsatzes ist am Außenmantel vorzugsweise gerändelt.

Bei einer bevorzugten Ausführungsform ist der Einsatz mit dem Hohlkörper verstemmt.

Bei einer bevorzugten Ausführungsform ist die Zylinderöffnung des Hohlkörpers im Durchmesser abgestuft, so daß sie sich von innen nach außen verjüngt. Die Montagepartie größeren Durchmessers des Einsatzes hat in dem inneren Abschnitt der Zylinderöffnung Spiel und in dem äußeren Abschnitt der Zylinderöffnung Paßsitz.

Die Erfindung wird im folgenden anhand eines in der Zeichnung dargestellten Ausführungsbeispiels näher erläutert. Es zeigen:

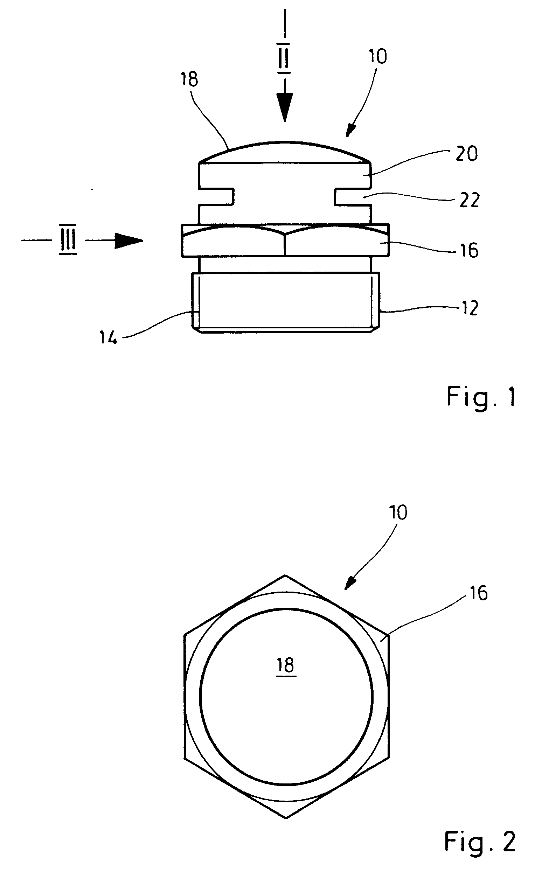

- Fig. 1: die Vorderansicht einer Be- und Entlüftungsverschraubung;
- Fig. 2: eine Draufsicht auf die Verschraubung mit Blick in Richtung II von Fig. 1;
- Fig. 3: eine Seitenansicht der Verschraubung mit Blick in Richtung III von Fig. 1;
- Fig. 4: eine Fig. 3 entsprechende diametrale Schnittansicht der Verschraubung;

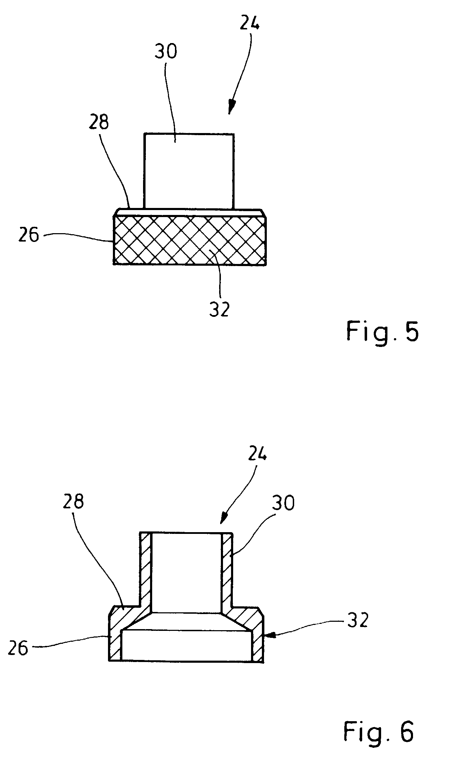

- Fig. 5: die Seitenansicht eines zu der Verschraubung gehörigen Einsatzes;
- Fig. 6: eine diametrale Schnittansicht des Einsatzes.

Die Verschraubung hat einen im wesentlichen kreiszylindrischen Hohlkörper 10, dessen inneres Ende als Gewindestutzen 12 mit einem Außengewinde 14 ausgebildet ist.

In axialer Mitte des Hohlkörpers 10 ist ein radial nach außen abstehender Flansch 16 vorgesehen, der vor dem Gewindestutzen 12 liegt. Der Flansch 16 hat einen Außensechskant, an dem ein Schraubenschlüssel angreift.

Das äußere Ende des Hohlkörpers 10 ist mit einer Stirnwand 18 verschlossen, die eine nach außen gewölbte Kuppe bildet.

Die Zylinderwand 20 des Hohlkörpers 10 ist zwischen Flansch 16 und Kuppe mit zwei Schlitzen 22 versehen, die sich axial auf gleicher Höhe in Umfangsrichtung erstrecken. Die Schlitze 22 sind gleich lang und liegen einander diametral gegenüber.

Der Hohlkörper 10 hat einen koaxial darin angeordneten Einsatz 24, der im wesentlichen kreiszylindrisch und im Durchmesser abgestuft ist. Der Einsatz 24 besteht aus einer inneren Montagepartie 26 größeren Durchmessers, einer radialen Ringstufe 28 und einem äußeren Rohrstutzen 30 kleineren Durchmessers.

Die Innenseite der Ringstufe 28 hat eine sich zu dem Rohrstutzen 30 hin verjüngende Konizität.

Die Montagepartie 26 des Einsatzes 24 ist am Außenmantel gerändelt 32.

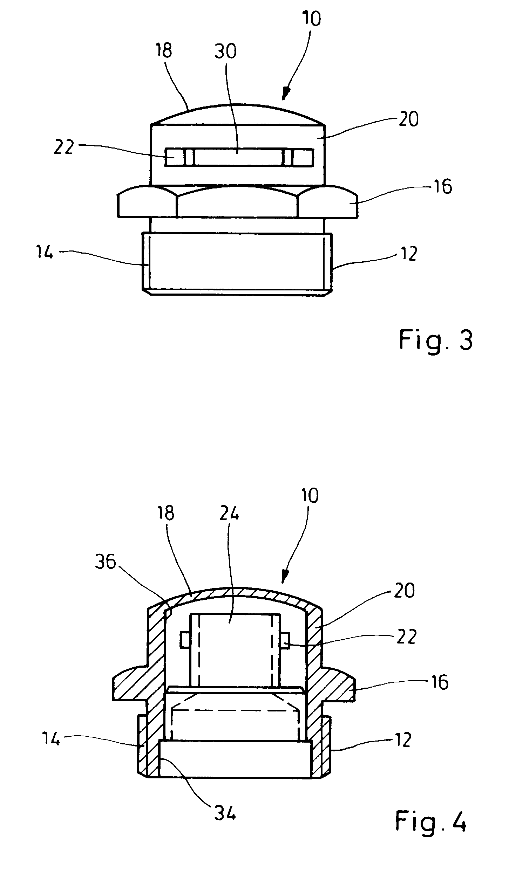

Wie man in Fig. 4 erkennt, ist die Zylinderöffnung des Hohlkörpers 10 im Durchmesser abgestuft, so daß sie sich von innen nach außen verjüngt. Die Montagepartie 26 des Einsatzes 24 hat in dem inneren Abschnitt 34 größeren Durchmessers der Zylinderöffnung Spiel.

Der Einsatz 24 wird mit dem Hohlkörper 10 verstemmt. Er nimmt mit seiner Montagepartie 26 in dem inneren Abschnitt 34 größeren Durchmessers der Zylinderöffnung eine Vormontagestellung ein.

Beim Verstemmen wird die Montagepartie 26 des Einsatzes 24 unter plastischer Verformung in den äußeren Abschnitt 36 kleineren Durchmessers der Zylinderöffnung hineingetrieben. Der Einsatz 24 hat hier Paßsitz.

Der Rohrstutzen 30 des Einsatzes 24 kommt koaxial mit Abstand von der Mantelinnenwand des Hohlkörpers 10 zu liegen. Er erstreckt sich über die Schlitze 22 hinweg in die Kuppe des Hohlkörpers 10 hinein und endet hier mit Abstand vor der gewölbten Stirnwand 18. Dadurch wird ein schmaler Ringspalt gebildet, über den und die Schlitze 22 ein labyrinthartiger Luftströmungsweg durch die Verschraubung besteht. Der Ringspalt und die Schlitze 22 sind so weit versetzt, daß kein Spritzwasser und keine Verunreinigungen in die Verschraubung eintreten können.

Zwischen dem Rohrstutzen 30 des Einsatzes 24 und der gewölbten Stirnwand 18 kann bei Bedarf eine Filterscheibe eingefügt werden (nicht dargestellt).

Zur Montage der erfindungsgemäßen Verschraubung an einem Schaltschrank o. ä. wird der Gewindestutzen 12 des Hohlkörpers 10 in eine passende Gewindebohrung in der Seitenwand oder Oberwand des Schaltschranks eingegeschraubt. Es gibt die Verschraubung in verschiedenen Größen, die durch den Gewindetyp identifiziert werden. Erwähnt seien die verbreitesten Panzergewindetypen PG 7, 9, 11, 13.5, 16, 21, 29, 36, 42 und 48 und die entsprechenden Größenabstufungen für metrische Gewinde nach ISO, Zollgewinde und NPT Gewinde.

### Liste der Bezugszeichen

- 10: Hohlkörper
- 12: Gewindestutzen
- 14: Außengewinde
- 16: Flansch
- 18: Stirnwand
- 20: Zylinderwand
- 22: Schlitz
- 24: Einsatz
- 26: Montagepartie
- 28: Ringstufe
- 30: Rohrstutzen
- 32: Rändelung
- 34: innerer Abschnitt der Zylinderöffnung
- 36: äußerer Abschnitt der Zylinderöffnung

## Patentansprüche

1. Be- und Entlüftungsverschraubung insbesondere für einen Schaltschrank mit einem im wesentlichen zylindrischen Hohlkörper (10), dessen inneres Ende als Gewindestutzen (12) ausgebildet und der außen mit einer Stirnwand (18) verschlossen und an seinem Mantel mit wenigstens einem Schlitz (22) versehen ist, und mit einem in den Hohlkörper (10) eingelassenen Rohrstutzen (30), der sich mit Abstand von der Mantelinnenwand des Hohlkörpers (10) über den Schlitz (22) hinweg bis dicht vor die Stirnwand (18) des Hohlkörpers (10) erstreckt.

2. Be- und Entlüftungsverschraubung nach Anspruch 1, dadurch gekennzeichnet, daß der Gewindestutzen (12) ein Außengewinde (14) hat.

3. Be- und Entlüftungsverschraubung nach Anspruch 1 oder 2, dadurch gekennzeichnet, daß der Hohlkörper (10) außen vor dem Gewindestutzen (12) einen Flansch (16) mit Außensechskant hat.

4. Be- und Entlüftungsverschraubung nach einem der Ansprüche 1 bis 3, dadurch gekennzeichnet, daß die Stirnwand (18) des Hohlkörpers (10) nach außen gewölbt ist.

5. Be- und Entlüftungsverschraubung nach einem der Ansprüche 1 bis 4, dadurch gekennzeichnet, daß sich der Schlitz (22) des Hohlkörpers (10) in Umfangsrichtung erstreckt.

6. Be- und Entlüftungsverschraubung nach einem der Ansprüche 1 bis 5, dadurch gekennzeichnet, daß der Hohlkörper (10) wenigstens zwei axial auf gleicher Höhe liegende Schlitze (22) hat.

7. Be- und Entlüftungsverschraubung nach einem der Ansprüche 1 bis 6, dadurch gekennzeichnet, daß der Rohrstutzen (30) zylindrisch und koaxial in dem Hohlkörper (10) aufgenommen ist.

8. Be- und Entlüftungsverschraubung nach einem der Ansprüche 1 bis 7, dadurch gekennzeichnet, daß der Hohlkörper (10) eine axiale Zylinderöffnung hat, und daß der Rohrstutzen (30) Teil eines im Durchmesser abgestuften zylindrischen Einsatzes (24) ist, dessen Montagepartie (26) größeren Durchmessers in die Zylinderöffnung paßt.

9. Be- und Entlüftungsverschraubung nach einem der Ansprüche 1 bis 8, dadurch gekennzeichnet, daß die Montagepartie (26) größeren Durchmessers des Einsatzes (24) am Außenmantel gerändelt (32) ist.

10. Be- und Entlüftungsverschraubung nach einem der Ansprüche 1 bis 9, dadurch gekennzeichnet, daß der Einsatz (24) mit dem Hohlkörper (10) verstemmt ist.

11. Be- und Entlüftungsverschraubung nach einem der Ansprüche 1 bis 10, dadurch gekennzeichnet, daß die Zylinderöffnung des Hohlkörpers (10) im Durchmesser abgestuft ist, so daß sie sich von innen nach außen verjüngt, und daß die Montagepartie (26) größeren Durchmessers des Einsatzes (24) in dem inneren Abschnitt (34) der Zylinderöffnung Spiel und in dem äußeren Abschnitt (36) der Zylinderöffnung Paßsitz hat.
